# EUROPEAN PATENT APPLICATION

(11) **EP 4 611 512 A1**
(43) Date of publication of application: **03.09.2025**
(21) Application number: 25150089.8
(22) Date of filing: 02.01.2025
(51) Int. Cl.: H10K 50/844, H10K 59/80

(54) **DISPLAY DEVICE**

(30) Priority: 27.02.2024 KR 20240028314
(71) Applicant: LG Display Co., Ltd., Seoul, 07336 (KR)
(72) Inventor: LEE, JongHwae, 10845 Paju-si (KR); KIM, KyuNam, 10845 Paju-si (KR)
(74) Representative: Beal, James Michael

(57) **Abstract**

A display device includes a first substrate on which display and non-display areas are defined; a thin film transistor over the first substrate at a portion corresponding to the display area; a planarization layer over the substrate and the thin film transistor at a portion corresponding to the display area and at least a portion of the non-display area; an organic light emitting diode on the planarization layer at a portion corresponding to the display area; a capping layer at a portion corresponding to the display area and the at least a part of the non-display area to cover the planarization layer and the organic light emitting diode at a portion corresponding to the display area and the at least a part of the non-display area; and an anti-oxidation layer covering an end of the planarization layer and an end of the capping layer in the non-display area.

## Description

### CROSS-REFERENCE TO RELATED APPLICATIONS

This application claims the priority of Korean Patent Application No. 10-2024-0028314 filed on February 27, 2024, in the Korean Intellectual Property Office.

### BACKGROUND

### Technical Field

The present disclosure relates to a display device, and more particularly, to a display device that suppresses degradation due to oxygen flowing from the outside.

### Discussion of the Related Art

Recently, as it enters an information era, a display field that visually expresses electrical information signals has been rapidly developed and in response to this, various display devices having excellent performances, such as thin-thickness, light weight, and low power consumption, have been developed. Examples of such a display device include a liquid crystal display device (LCD) and an organic light emitting display device (OLED).

The organic light emitting display device is a self-emitting display device so that a separate light source is not necessary, which is different from the liquid crystal display device. Therefore, the organic light emitting display device may be manufactured to have light weight and small thickness. Further, because the organic light emitting display device is driven at a low voltage, it is advantageous not only in terms of power consumption, but also in terms of the color expression, the response speed, the viewing angle, and the contrast ratio (CR), so that the light emitting display device is being studied as next generation displays.

However, the light emitting diode of the organic light emitting display device includes an organic material that is vulnerable to oxygen or moisture. When oxygen and moisture permeate the light emitting diode, layers that configure the light emitting diode may become oxidized, thereby causing a dark spot defect and increased an electric resistance. As a result, the efficiency of the device may become degraded.

Therefore, studies regarding techniques for sealing the light emitting diode to minimize, or at least reduce, permeation of oxygen or moisture from the outside are actively being developed.

### SUMMARY

To seal the organic light emitting diode, a method of forming an organic light emitting diode on a bottom substrate that is an array substrate and bonding the bottom substrate with a top substrate that is an encapsulation substrate using an adhesive filler to seal the organic light emitting diode is being used. At this time, to seal the adhesive filler, a dam is disposed to enclose the adhesive filler between the bottom substrate and the top substrate. Therefore, the permeation of the moisture or oxygen from a side surface of the display device may be suppressed.

The dam includes a spacer to maintain a gap between the top substrate and the bottom substrate. The encapsulation layer is pressed by the spacer to be cracked in the vicinity of the display area and when a crack is generated, there may be a problem in that oxygen flowing from the outside permeates to the organic light emitting diode. As described above, when the oxygen flows into the organic light emitting diode, layers that configure the organic light emitting diode may become oxidized to cause a dark spot defect. For example, when the cathode comes into contact with oxygen, the cathode may be oxidized to cause dark spots, which become dead pixels as time passes, thereby degrading the display quality. Further, the electric resistance is increased due to the oxygen so that the luminous efficiency may be degraded. Therefore, when a filler that absorbs oxygen is dispersed in the dam to partially block the inflow of oxygen, a ratio of moisture absorbent is relatively reduced, which may cause another problem in that the moisture barrier characteristic is degraded.

Accordingly, embodiments of the present disclosure are directed to a display device that substantially obviates one or more of the problems due to limitations and disadvantages of the related art.

An aspect of the present disclosure is to provide a display device that suppresses or delays oxygen flowing from the outside from permeating the display area to minimize or reduce degradation of the organic light emitting diode due to oxygen.

Another aspect of the present disclosure is to improve a reliability of the display device that additionally blocks oxygen while maintaining a moisture barrier characteristic to be high.

Additional features and aspects will be set forth in the description that follows, and in part will be apparent from the description, or may be learned by practice of the inventive concepts provided herein. Other features and aspects of the inventive concepts may be realized and attained by the structure particularly pointed out in the written description, or derivable therefrom, and the claims hereof as well as the appended drawings.

To achieve these and other aspects of the inventive concepts, as embodied and broadly described herein, a display device includes a first substrate on which a display area and a non-display area around the display area are defined; a thin film transistor over the first substrate at a portion corresponding to the display area; a planarization layer over the first substrate and the thin film transistor at a portion corresponding to the display area and at least a portion of the non-display area; an organic light emitting diode on the planarization layer at a portion corresponding to the display area; a capping layer at a portion corresponding to the display area and the at least a part of the non-display area to cover the planarization layer and the organic light emitting diode at a portion corresponding to the display area and the at least a part of the non-display area; and an anti-oxidation layer covering an end of the planarization layer and an end of the capping layer in the non-display area.

In another aspect, a display device, having a display area and a non-display area, comprises a first substrate; a planarization layer over the first substrate in the display area and in at least a portion of the non-display area; an organic light emitting diode on the planarization layer in the display area; a capping layer, in the display area and in the at least the portion of the non-display area, covering the organic light emitting diode; an anti-oxidation layer, in the non-display area, covering an end of the planarization layer and an end of the capping layer.

In another aspect, a display device, having a display area and a non-display area, comprises a first substrate; a second substrate; a dam in the non-display area between the first and second substrates to seal the display area; a planarization layer in the display area and in the non-display area to have a portion overlapping the dam; and an anti-oxidation layer covering the portion of the planarization layer overlapping the dam.

Other detailed matters of example embodiments are included in the detailed description and the drawings.

According to the present disclosure, the display device suppresses or delays oxygen flowing from the outside from permeating into the organic light emitting diode of the display area to minimize or reduce degradation of the organic light emitting diode due to oxygen.

Further, according to the present disclosure, a display device with an improved reliability is provided by additionally blocking oxygen while maintaining a moisture barrier characteristic to be high.

Further, according to the present disclosure, in the display device, the anti-oxidation layer functions as a ground unit to suppress voltage fluctuation, which results in improving the display quality.

It is to be understood that both the foregoing general description and the following detailed description are exemplary and explanatory and are intended to provide further explanation of the inventive concepts as claimed.

### BRIEF DESCRIPTION OF DRAWINGS

The accompanying drawings, which are included to provide a further understanding of the disclosure and are incorporated in and constitute a part of this application, illustrate embodiments of the disclosure and together with the description serve to explain various principles. In the drawings:
FIG. 1 is a plan view of a display device according to an example embodiment of the present disclosure;
FIG. 2 is a view for explaining the placement structure of a dam and an anti-oxidation layer of a display device according to an example embodiment of the present disclosure;
FIG. 3 is a cross-sectional view of one sub pixel of a display device according to an example embodiment of the present disclosure;
FIG. 4 is a cross-sectional view taken along the line I-I' of FIG. 1;
FIG. 5 is a cross-sectional view taken along the line II -II' of FIG. 1;
FIG. 6 is a cross-sectional view taken along the line III-IIF of FIG. 1; and
FIG. 7 is a cross-sectional view taken along the line I-I' of FIG. 2.

### DETAILED DESCRIPTION

Advantages and characteristics of the present disclosure and a method of achieving the advantages and characteristics will be clear by referring to example embodiments described below in detail together with the accompanying drawings. However, the present disclosure is not limited to the example embodiments disclosed herein but will be implemented in various forms. The embodiments are provided by way of example only so that those skilled in the art can fully understand the disclosures of the present disclosure and the scope of the present disclosure.

The shapes, sizes, ratios, angles, numbers, and the like illustrated in the accompanying drawings for describing the example embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "consist of' used herein are generally intended to allow other components to be added unless the terms are used with the term "only." Any references to singular may include plural unless expressly stated otherwise.

Components are interpreted to include an ordinary error range even if not expressly stated.

When the position relation between two parts is described using the terms such as "on," "above," "below," and "next," one or more parts may be positioned between the two parts unless the terms are used with the term "immediately" or "directly."

When an element or layer is disposed "on" another element or layer, another layer or another element may be interposed directly on the other element or therebetween.

Although the terms "first," "second," and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Hereinafter, a display device according to example embodiments of the present disclosure will be described in detail with reference to accompanying drawings.

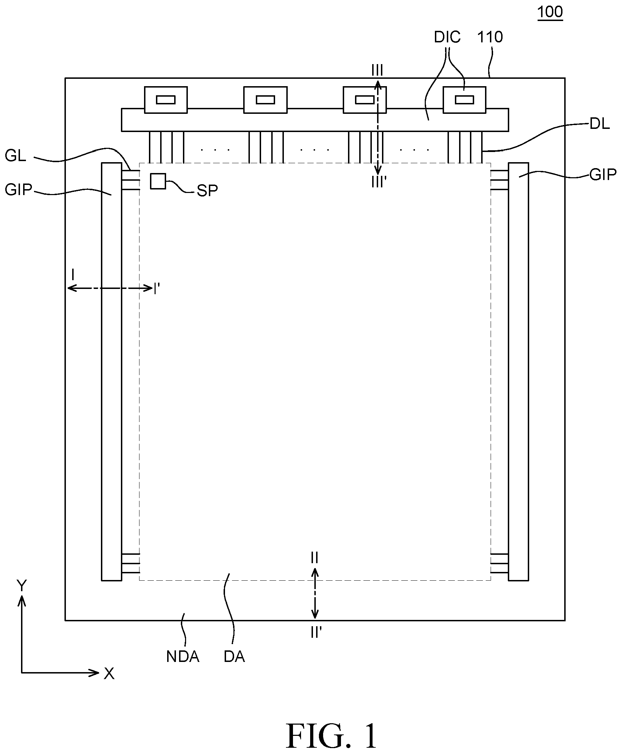

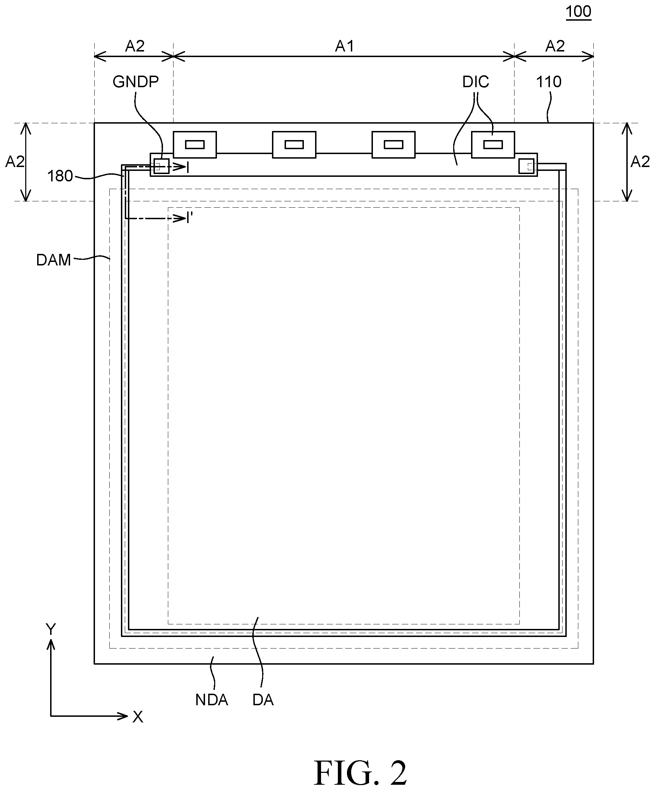

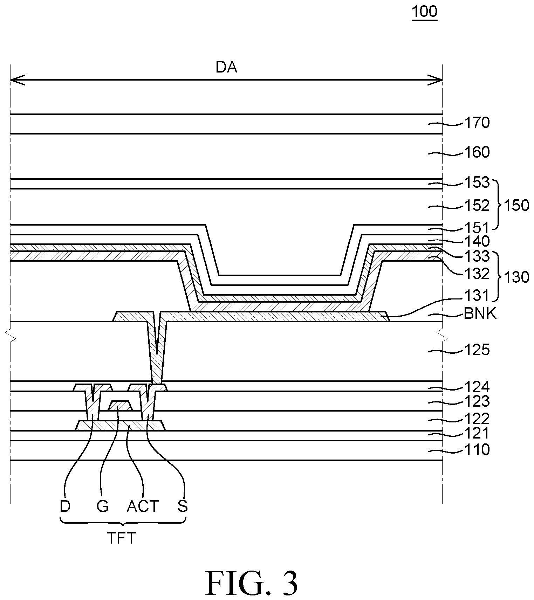

FIG. 1 is a plan view of a display device according to an example embodiment of the present disclosure and FIG. 2 is a view for explaining the placement structure of a dam and an anti-oxidation layer of a display device according to an example embodiment of the present disclosure. FIG. 3 is a cross-sectional view of one sub pixel of a display device according to an example embodiment of the present disclosure.

As shown in FIGs. 1 to 3, a display device 100 according to an example embodiment of the present disclosure includes a first substrate 110, a thin film transistor TFT, a planarization layer 125, an organic light emitting diode 130, a capping layer 140, a gate pad unit GIP, a source pad unit DIC, a bank BNK, an encapsulation layer 150, an adhesive layer 160, a second substrate 170, a dam DAM, and an anti-oxidation layer 180. The first substrate 110 includes areas defined as a display area DA and a non-display area NDA. The display area DA is an area that includes a plurality of sub pixels SP to display images and the non-display area NDA is an area in which no image is displayed.

In the display area DA, a plurality of sub pixels SP that is divided by a plurality of data lines DL and a plurality of gate lines GL intersecting each other and is connected to the plurality of data lines DL and the plurality of gate lines GL is disposed. The sub pixel SP is an element for representing one color and each sub pixel SP may be configured to emit light with any one of red, green, blue, and white, but is not limited thereto.

In the non-display area NDA, various wiring lines, driving ICs, printed circuit boards, etc. for driving the sub pixels SP and a sub pixel circuit disposed in the display area DA may be disposed. The non-display area NDA is configured by four surfaces that enclose four sides of the display area DA. The non-display area NDA includes a first surface and a second surface that are parallel to each other and extend in a first direction and a third surface and a fourth surface that are parallel to each other and extend in a second direction. For example, the first direction is a Y-axis direction and the second direction is an X-axis direction, but the present disclosure is not limited thereto.

For example, in the non-display area NDA, a gate pad unit GIP and a source pad unit DIC may be disposed. The gate pad unit GIP may be disposed on each of the first surface and the second surface of the non-display area NDA and the source pad unit DIC may be disposed on the third surface. The fourth surface may be a non-pad unit in which the gate pad unit GIP or the source pad unit DIC is not disposed. However, the present disclosure is not limited thereto and positions of the gate pad unit GIP, the source pad unit DIC, and the non-pad unit may be changed as needed. Even though, in FIG. 1, it is illustrated that the gate pad unit GIP is disposed on each of the first surface and the second surface, the present disclosure is not limited thereto. The gate pad unit GIP may be disposed on only any one of the first surface and the second surface depending on a driving method or a design.

The source pad unit DIC is connected to each of the plurality of data line DL to supply a data voltage. The source pad unit DIC includes at least one data driving IC and each data driving IC may be connected to the data line DL in a chip on film (COF) manner or a tape automated bonding (TAB) manner. According to an example embodiment, each data driving IC is mounted in a flexible film by a chip on film (COF) in which one end of the flexible film is bonded on the printed circuit board and the other end is bonded to a data driving IC pad unit on the first substrate 110, but is not limited thereto.

The gate pad unit GIP is connected to each of the plurality of gate lines GL to output a gate signal. When the gate signal is supplied to the gate line GL, the data voltage may be applied to a sub pixel SP connected to a specific gate line GL. The gate pad unit GIP may be connected to the gate line in the gate-in-panel manner in which the gate driving IC is directly formed on the non-display area NDA of the first substrate 110, but is not limited thereto.

The first substrate 110 is a base material that supports various elements for driving the display device 100. The first substrate 110 may be formed of a material having excellent insulating property and anti-moisture permeability. For example, the first substrate 110 may be a glass substrate or a plastic substrate, but is not limited thereto. For example, the plastic substrate may be formed of a material selected from polyethylene terephthalate, polyimide, polyamide, and polycarbonate, but is not limited thereto.

A plurality of thin film transistors TFT and a plurality of organic light emitting diodes 130 are disposed on the display area DA of the first substrate 110. The thin film transistor TFT and the organic light emitting diode 130 are disposed in each of the plurality of sub pixels SP.

A buffer layer 121 may be formed on the first substrate 110 before forming the thin film transistor TFT. The buffer layer 121 enhances the adhesiveness between an active layer ACT or various conductive material layers and the first substrate 110. Further, the buffer layer 121 may block foreign materials above the first substrate 110 from the outside, moisture flowing from the outside, etc. The buffer layer 121 may be formed as a single layer and may be formed as multiple layers as needed. For example, the buffer layer 121 may be formed of an inorganic material, such as silicon oxide, silicon nitride, or silicon oxynitride, but is not limited thereto. The buffer layer 121 may be formed to extend to the non-display area NDA.

The thin film transistor TFT is disposed on the buffer layer 121. In the drawing, among various thin film transistors that may be included in the display device 100, only a driving thin film transistor is illustrated for the sake of convenience, but a switching thin film transistor, a capacitor, etc. may also be included.

The thin film transistor TFT is an element for driving the organic light emitting diode 130 disposed in the display area DA. The thin film transistor TFT includes a gate electrode G, an active layer ACT, a source electrode S, and a drain electrode D. The active layer ACT is disposed on the buffer layer 121. The active layer ACT may be formed of a metal oxide semiconductor, amorphous silicon, or low temperature polycrystalline silicon, but is not limited thereto. A gate insulating layer 122 is disposed on the active layer ACT. For example, the gate insulating layer 122 may be formed of an inorganic material, such as silicon oxide, silicon nitride, or silicon oxynitride, but is not limited thereto. Further, the gate insulating layer 122 may be configured as a single layer or multiple layers. The gate electrode G is disposed on the gate insulating layer 122. An interlayer insulating layer 123 is disposed on the gate electrode G to cover the gate electrode. For example, the interlayer insulating layer 123 may be formed of an inorganic material, such as silicon oxide, silicon nitride, or silicon oxynitride, but is not limited thereto. Further, the interlayer insulating layer 123 may be configured as a single layer or multiple layers. Each of the source electrode S and the drain electrode D is disposed on the interlayer insulating layer 123 and is connected to the active layer ACT by means of a contact hole that passes through the gate insulating layer 122 and the interlayer insulating layer 123. The structure of the thin film transistor TFT is not limited thereto and may vary depending on a driving method or a design. The gate insulating layer 122 and the interlayer insulating layer 123 may be formed to extend to the non-display area NDA.

A protection layer 124 is disposed to cover the thin film transistor TFT. The protection layer 124 may include a contact hole to electrically connect the source electrode S or the drain electrode D of the thin film transistor TFT to the organic light emitting diode 130. For example, the protection layer 124 may be formed of an inorganic material, such as silicon oxide, silicon nitride, or silicon oxynitride, but is not limited thereto. The protection layer 124 may be formed to extend to the non-display area NDA. If necessary, the protection layer 124 may be selectively omitted.

In the drawing, it is illustrated that the gate insulating layer 122, the interlayer insulating layer 123, and the protection layer 124 provide flat surfaces, respectively, but the present disclosure is not limited thereto. Depending on the process method or the design, each of the gate insulating layer 122, the interlayer insulating layer 123, and the protection layer 124 may be formed as a conformal thin film to have a constant thickness regardless of the shape of the lower layers. In this case, upper surfaces of the gate insulating layer 122, the interlayer insulating layer 123, and the protection layer 124 may not be flat.

A planarization layer 125 may be disposed on the protection layer 124. The planarization layer 125 planarizes a top surface of the thin film transistor TFT. The planarization layer 125 may be formed of an organic material to easily provide a flattened surface. For example, the planarization layer 125 may be formed of an organic material, such as polyimide, benzocyclobutene-based resin, and acrylate resin, but is not limited thereto. The planarization layer 125 may include a contact hole to electrically connect the source electrode S or the drain electrode D of the thin film transistor TFT to the organic light emitting diode 130. The planarization layer 125 may be formed to extend to the non-display area NDA.

The organic light emitting diode 130 is disposed on the planarization layer 125 in the display area DA. The organic light emitting diode 130 may be disposed to correspond to each of the plurality of sub pixels SP. The organic light emitting element 130 includes an anode 131, an organic emission layer 132, and a cathode 133.

The anode 131 is disposed on the planarization layer 125. The anode 131 is formed to be separated for each of the plurality of sub pixels SP. The anode 131 is disposed on the planarization layer 125 to correspond to the emission area of each sub pixel SP. The anode 131 may be electrically connected to the source electrode S or the drain electrode D of the thin film transistor TFT by means of the contact hole.

The anode 131 may be configured by a conductive material having a high work function. For example, the anode 131 is formed of a transparent conductive oxide, such as indium-tin-oxide (ITO), indium-zinc-oxide (IZO), or indium-tin-zinc-oxide (ITZO), but is not limited thereto. When the organic light emitting diode 130 operates in a top emission type, the anode 131 may be formed to further include a reflective material to have a reflection characteristic and if necessary, a reflection layer may be separately provided below the anode 131.

A bank BNK may be disposed on the planarization layer 125 and the anode 131. The bank BNK defines an emission area of the organic emission layer 132. For example, the bank BNK may be disposed on the planarization layer 125 to expose at least a part of the anode 131. The bank BNK may be disposed on the planarization layer 125 to cover an end of the anode 131. The bank BNK may be formed to extend to the non-display area NDA.

The organic emission layer 132 is disposed on the anode 131. The organic emission layer 132 includes a light emitting material to emit light. The organic emission layer 132 may be formed as one layer without being separated for every sub pixel SP. In the display area DA, the organic emission layer 132 is disposed to cover the anode 131 and the bank BNK, but the present disclosure is not limited thereto. The organic emission layer 132 may be formed to be separated for each of the plurality of sub pixels SP depending on the driving method or the design.

The cathode 133 is disposed on the organic emission layer 132. The cathode 133 may be formed as one layer without being separated for every sub pixel SP. The cathode 133 may be formed of a metallic material or a transparent conductive oxide having a low work function. When the cathode 133 is formed of a metallic material, the cathode 133 is formed with a very thin thickness to be substantially transparent. For example, the cathode 133 may be formed of a metal material selected from calcium (Ca), barium (Ba), aluminum (Al), silver (Ag), and alloys including one or more of them, but is not limited thereto.

The capping layer 140 is disposed on the organic light emitting diode 130. For example, the capping layer 140 is disposed on the cathode 133 of the organic light emitting diode 130. The capping layer 140 may be formed to extend from the display area DA to the non-display area NDA. The capping layer 140 covers the organic light emitting diode 130 to protect the organic light emitting diode 130. Further, the capping layer 140 may protect the organic light emitting diode 130 from ultraviolet rays transmitted from the outside. Further, the capping layer 140 allows light emitted from the organic emission layer 132 to be efficiently discharged to the outside of the display device 100 to improve a light extraction efficiency. Therefore, the luminance of the display device 100 may be improved.

The encapsulation layer 150 is disposed on the capping layer 140. The encapsulation layer 150 blocks the moisture or oxygen flowing from the outside to suppress oxidation and deterioration of the organic light emitting diode 130. The encapsulation layer 150 may be formed as a single layer or multiple layers. For example, the encapsulation layer 150 may be formed as a multi-layered layer including an inorganic encapsulation layer formed of an inorganic material and an organic encapsulation layer formed of an organic material. For example, the encapsulation layer 150 may include a first inorganic encapsulation layer 151 disposed on the capping layer 140, an organic encapsulation layer 152 disposed on the first inorganic encapsulation layer 151 and a second inorganic encapsulation layer 153 disposed on the organic encapsulation layer 152. In this case, the moisture and oxygen flowing from the outside are effectively blocked and the organic light emitting diode 130 are protected to ensure the excellent reliability. The encapsulation layer 150 may be formed to extend to the non-display area NDA.

The second substrate 170 is disposed on the encapsulation layer 150 to be opposite to the first substrate 110. The second substrate 170 protects the organic light emitting diode 130 from the external shock and suppresses the permeation of foreign materials, moisture, or oxygen.

Even though it is not illustrated in the drawing, when the organic light emitting diode 130 emits white light, a color filter layer may be disposed on one surface of the second substrate 170 that is opposite to the organic light emitting diode 130. The color filter layer includes a plurality of color filters corresponding to the plurality of sub pixels, respectively, and a black matrix disposed between the plurality of color filters. Each of the plurality of color filters emits white light emitted from the organic light emitting diode 130 as light with a color corresponding to each sub pixel. By doing this, full-color may be implemented. The black matrix suppresses color mixture of light emitted from adjacent sub pixels.

The adhesive layer 160 is disposed between the second substrate 170 and the encapsulation layer 150. The adhesive layer 160 is filled in a space between the encapsulation layer 150 and the second substrate 170 and bonds the first substrate 110 and the second substrate 170. The adhesive layer 160 includes an adhesive transparent resin and may selectively further include a hygroscopic filler as needed. The adhesive resin may use a transparent material so as not to degrade the light extraction efficiency with the adhesiveness. The hygroscopic filler absorbs oxygen or moisture to delay the oxidation and deterioration of the light emitting diode 130. The adhesive layer 160 may be disposed to extend to the non-display area NDA.

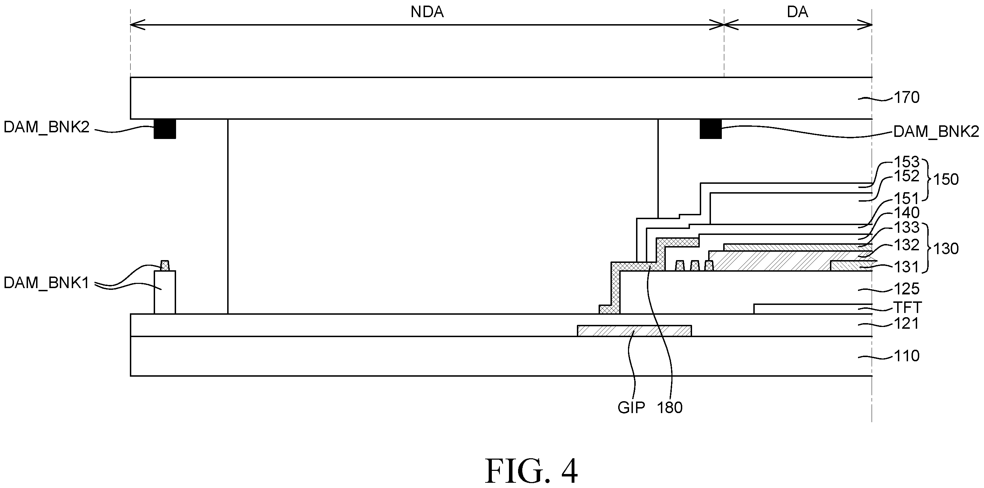

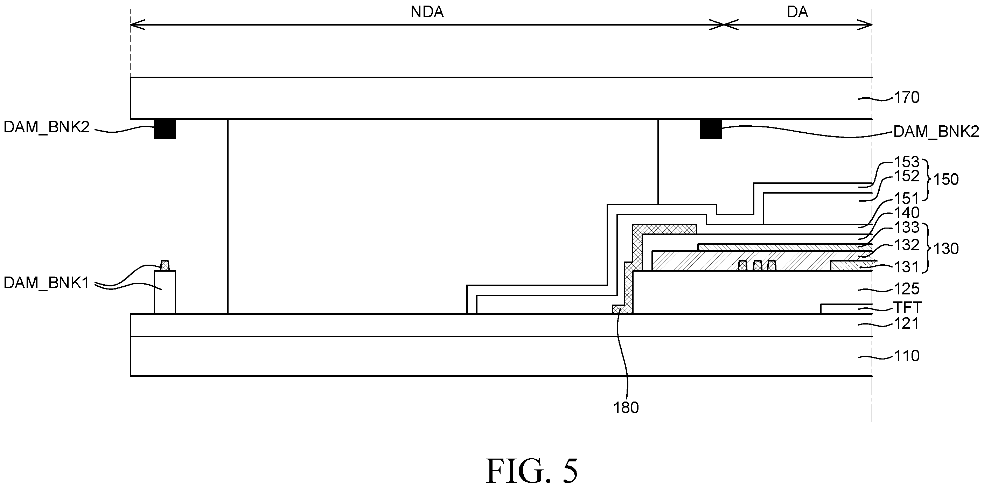

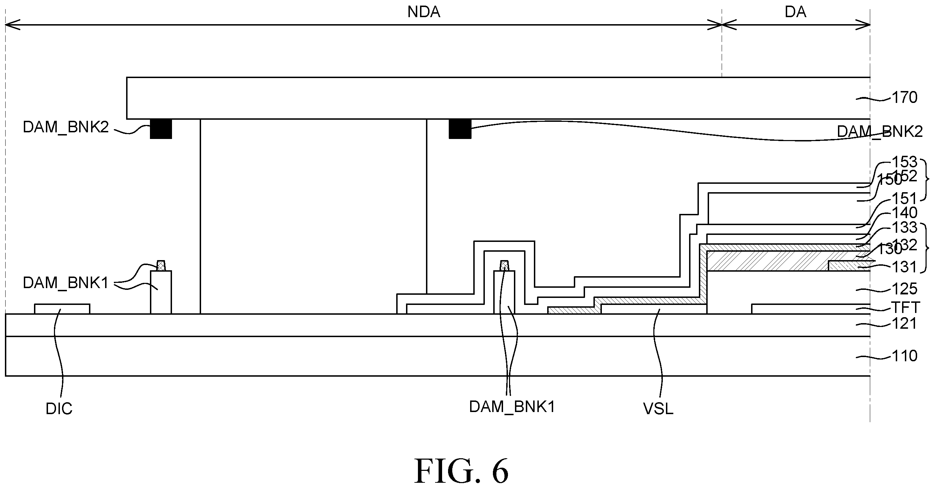

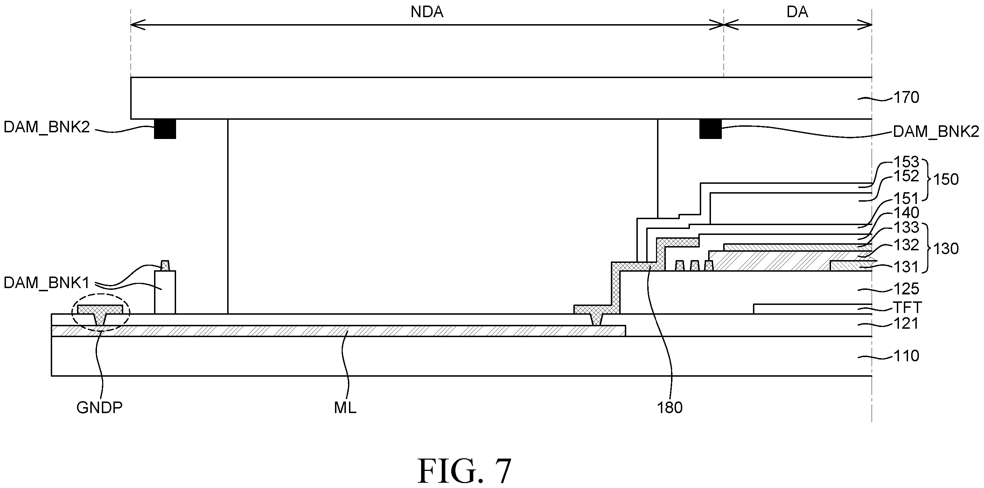

Hereinafter, components disposed in the non-display area NDA will be described in detail with reference to FIGs. 1 to 7 together. In FIG. 2, for the convenience of description, remaining components excluding a source pad unit DIC, a ground pad unit GNDP, a dam DAM, and an anti-oxidation layer 180 are omitted. FIG. 4 is a cross-sectional view taken along the line I-I' of FIG. 1, FIG. 5 is a cross-sectional view taken along the line II-II' of FIG. 1, FIG. 6 is a cross-sectional view taken along the line III-IIF of FIG. 1, and FIG. 7 is a cross-sectional view taken along the line I-I' of FIG. 2. In FIGs. 4 to 7, the gate insulating layer 122, the interlayer insulating layer 123, and the protection layer 124 are not illustrated.

As described above, the non-display area NDA is configured by four surfaces to enclose the display area DA. For example, the non-display area NDA includes a first surface and a second surface that are parallel to each other and extend in a Y-axis direction, respectively, and a third surface and a fourth surface that are parallel to each other and extend in an X-axis direction, respectively. Further, the gate pad unit GIP may be disposed on each of the first surface and the second surface of the non-display area NDA and the source pad unit DIC may be disposed on the third surface. The fourth surface may be a non-pad unit in which the gate pad unit GIP or the source pad unit DIC is not disposed. A specific structure for every area of the non-display area NDA will be described below.

The dam DAM is disposed in the non-display area NDA. The dam DAM is disposed between the first substrate 110 and the second substrate 170 to enclose the display area DA. The dam DAM is disposed to enclose the adhesive layer 160 to seal the adhesive layer 160. The dam DAM reinforces the adhesiveness between the first substrate 110 and the second substrate 170 and blocks moisture or oxygen permeating from the side surface. The dam DAM may include a sealant, a moisture absorbent, and a spacer. The sealant provides adhesiveness to bond the first substrate 110 and the second substrate 170 and the moisture absorbent is dispersed in the sealant to absorb moisture flowing from the outside to block or delay the permeation of moisture. The spacer may be a spherical particle with a large diameter. Therefore, the spacer maintains a gap between the first substrate 110 and the second substrate 170.

During the process of bonding the first substrate 110 and the second substrate 170 using the dam DAM and the adhesive layer 160, the adhesive layer 160 having a higher fluidity may spread to the dam DAM. As described above, when the adhesive layer 160 spreads to the dam DAM, the dam DAM is pressurized and the organic light emitting diode 130 and the adhesive layer 160 may not be completely sealed. Therefore, dam banks DAM_BNK may be disposed in the vicinity of the dam DAM. The dam bank DAM_BNK is disposed to be adjacent to the dam DAM to suppress the dam DAM from being pushed even though the dam DAM is pressurized during the process of bonding the first substrate 110 and the second substrate 170.

For example, the dam bank DAM_BNK may include a first dam bank DAM_BNK1 disposed on the first substrate 110 and a second dam bank DAM_BNK2 disposed on the second substrate 170. The first dam bank DAM_BNK1 is disposed on an outer side surface of the display device 100 between both side surfaces of the dam DAM to suppress a defect caused when the dam DAM is pushed. If necessary, the first dam bank DAM_BNK1 may also be disposed in an inner side surface of the dam DAM adjacent to the display area DA. In FIG. 6, on the third surface of the non-display area NDA in which the source pad unit DIC is disposed, the first dam bank DAM_BNK1 may be disposed on both side surfaces of the dam DAM, respectively. The source pad unit DIC including various pads and a plurality of wiring lines that is connected to the source pad unit DIC are disposed on the third surface of the non-display area NDA. The first dam bank DAM_BANK_1 may be disposed on both side surfaces of the dam DAM, respectively, so as not to cause damage of the source pad unit DIC and the plurality of wiring lines, but the present disclosure is not limited thereto. For the convenience of process, the first dam bank DAM_BNK_1 may be formed of the same material during the same process as the planarization layer 125 and/or the bank BNK.

The second dam bank DAM_BNK2 is disposed on the second substrate 170. The second dam bank DAM _BNK2 may be disposed on the second substrate 170 to be located on both side surfaces of the dam DAM, respectively. Therefore, the dam DAM may be suppressed from being pushed due to the fluidity of the adhesive layer 160. For the convenience of process, the second dam bank DAM_BNK_2 may be formed of the same material by the same process as the black matrix disposed on the second substrate 170, but is not limited thereto.

As described above, the dam DAM includes a spacer. During the process of bonding the first substrate 110 and the second substrate 170 using the dam DAM and the adhesive layer 160, the inorganic encapsulation layers 151 and 153 that are in contact with the dam DAM are pressurized by the spacer, which causes the cracks. When the inorganic encapsulation layers 151 and the 153 are cracked, the oxygen may permeate through the crack. As described above, the permeating oxygen flows into the display area DA through a layer formed of an organic material to degrade the organic light emitting diode 130.

Therefore, in the display device 100 according to the example embodiments of the present disclosure, an anti-oxidation layer 180 is formed in the non-display area NDA. The anti-oxidation layer 180 may be disposed in the non-display area NDA to cover an end of a layer that is formed of an organic layer having a relative oxygen permeability. For example, the anti-oxidation layer 180 may be disposed to cover ends of the planarization layer 125 and the capping layer 140, respectively, in the non-display area NDA. However, the present disclosure is not limited thereto and when the capping layer 140 is formed of a material having a high oxygen barrier characteristic, the anti-oxidation layer 180 may be disposed to cover an end of the planarization layer 125.

The anti-oxidation layer 180 may be formed of metal that reacts with oxygen to form an oxide film. For example, the anti-oxidation layer 180 may be formed to include one or more metals selected from aluminum, lithium, magnesium, silver, copper, and calcium. When the oxygen flows from the outside, the metal materials react with oxygen to form an oxide film, such as Al₂O₃, Li₂O, MgO, or Ag₂O. Therefore, when the inorganic encapsulation layers 151 and 153 are pressurized by the spacer included in the dam DAM to be cracked, even though oxygen flows thereinto through the crack, the permeation of the oxygen into the display area DA due to the reaction of the anti-oxidation layer 180 and the oxygen may be suppressed or delayed. Further, the above-described metal materials may be subject to the deposition process so that there is a process advantage of easily forming the anti-oxidation layer 180 in a specific area.

The anti-oxidation layer 180 is formed along an area in which the gate pad unit GIP is disposed and a non-pad unit in the non-display area NDA and a part thereof may be disposed to overlap an area in which the source pad unit DIC is disposed. As illustrated in FIGs. 1 and 2, the anti-oxidation layer 180 may be continuously formed along the first surface and the second surface on which the gate pad unit GIP is disposed in the non-display area NDA and the fourth surface that is a non-pad unit. Further, at least a part of the anti-oxidation layer 180 further extends toward the source pad unit DIC more than the end of the gate pad unit GIP of the first surface and the end of the gate pad unit GIP of the second surface to overlap an edge of an area where the source pad unit DIC is disposed. The anti-oxidation layer 180 may be disposed to be electrically connected to the ground pad GNDP disposed in each of both ends of the source pad unit DIC, which will be described below.

In FIG. 2, the third surface of the non-display area NDA in which the source pad unit DIC is disposed may include areas that are divided into a first area A1 (a middle area) and a second area A2 (an adjacent area). The first area A1 is an area in which a data driving IC connected to the data line DL is disposed. The second area A2 is adjacent to each of both ends of the first area A1 and the ground pad GNDP is disposed in the second area. As described above, the anti-oxidation layer 180 may be formed of a metal material. Various wiring lines connected to the data driving IC are disposed on the third surface of the non-display area NDA on which the source pad unit DIC is disposed. Therefore, when the anti-oxidation layer 180 formed of a metal material is formed in an area in which a plurality of wiring lines is located, operational problems may occur due to interference with wiring lines. Further, a short between the plurality of wiring lines included in the source pad unit DIC and the anti-oxidation layer 180 may occur.

Therefore, the anti-oxidation layer 180 may be formed along an area excluding the first area A1 in which the data driving IC and the plurality of wiring lines are located, from an area in which the source pad area DIC is disposed, but the present disclosure is not limited thereto. The anti-oxidation layer 180 may vary depending on a design structure of the display device 100 and a placement structure of the wiring line.

The anti-oxidation layer 180 may be formed to be electrically connected to the ground pad GNDP disposed in each of both edges of an area in which the source pad unit DIC is disposed. In this case, the anti-oxidation layer 180 not only suppresses and delays the permeation of the oxygen, but also serves as a ground line. Therefore, the fluctuation of the driving voltage due to static electricity may be minimized, or at least reduced, and an operation failure of the element and the display quality may be improved. For example, the ground pad GNDP may be located on both ends of the source pad unit DIC. In this case, interference between the anti-oxidation layer 180 and the plurality of wiring lines included in the source pad unit DIC and the operation failure thereby may be suppressed, but it is not limited thereto and it may vary depending on the design structure.

Hereinafter, a specific cross-section structure of every area of the non-display area NDA and a placement structure of the anti-oxidation layer thereby will be described.

FIG. 4 is a cross-sectional view taken along the line I-I' of FIG. 1 and, for example, may be a cross-sectional view of a partial area of the non-display area NDA in which the gate pad unit GIP is disposed. With reference to FIGs. 1 to 4 together, the gate pad unit GIP may be disposed on the first surface and the second surface that extend in the Y-axis direction, among four surfaces of the non-display area NDA. However, it is not limited thereto and it may vary according to the driving method or the design. The gate pad unit GIP may include a plurality of gate driving lines and a gate driving circuit. For example, the plurality of gate driving lines may be formed of the same electrode material by the same process as the gate electrode G, but is not limited thereto. For example, each of the plurality of gate driving lines GL may be a clock signal line or a start signal line, but is not limited thereto. A gate driving circuit is disposed to be connected to a gate line GL connected to each of the plurality of sub pixels SP disposed in the display area DA.

The buffer layer 121 extends to the non-display area NDA to be substantially formed on the entire surface of the first substrate 110. In the non-display area NDA in which the gate pad unit GIP is disposed, the planarization layer 125 is disposed to extend to the non-display area NDA to overlap at least a part of the gate pad unit GIP. In this area, an end of the planarization layer 125 may be disposed to further extend toward an outer periphery of the non-display area NDA more than an end of the emission layer 132 and an end of the cathode 133. For example, each of the end of the emission layer 132 and the end of the cathode 133 is located on the planarization layer 125.

The capping layer 140 may be disposed to extend to the non-display area NDA to overlap at least a part of the gate pad unit GIP. The capping layer 140 is disposed to continuously cover side surfaces from top surfaces of the emission layer 132 and the cathode 133. The capping layer 140 is disposed to completely cover the end of the emission layer 132 and the end of the cathode 133. The end of the capping layer 140 may be disposed to be located on the top surface of the planarization layer 125.

The anti-oxidation layer 180 is disposed to cover the end of the capping layer 140 and the end of the planarization layer 125. The anti-oxidation layer 180 is disposed to continuously cover from the end of the capping layer 140 to the end of the planarization layer 125. The anti-oxidation layer 180 is disposed to cover a part of the top surface and the side surface of the planarization layer 125 that protrudes to the outer periphery of the non-display area NDA more than a part of the top surface and a side surface of the capping layer 140 and the end of the capping layer 140.

The first and second inorganic encapsulation layers 151 and 153 are disposed to extend from the display area DA to at least a part of the non-display area NDA. The first and second inorganic encapsulation layers 151 and 153 are disposed to completely cover the capping layer 140 and a part of the anti-oxidation layer 180. Therefore, the moisture and oxygen may be suppressed from permeating the organic light emitting diode 130 from the outside.

The dam DAM is disposed on the second inorganic encapsulation layer 153. In the non-display area NDA in which the gate pad unit GIP is disposed, at least a part of the dam DAM overlaps at least a part of the first and second inorganic encapsulation layers 151 and 153, the planarization layer 125, and the capping layer 140, respectively. A thickness of the dam DAM is relatively small in a portion that overlaps at least a part of the first and second inorganic encapsulation layers 151 and 153, the planarization layer 125, and the capping layer 140. Therefore, in an area in which the dam DAM overlaps the first and second inorganic encapsulation layers 151 and 153, the planarization layer 125, and the capping layer 140, the first and second inorganic encapsulation layers 151 and 153 are more vulnerable to pressurization by the spacer.

In the display device 100 of the present disclosure, in the area in which the dam DAM overlaps the first and second inorganic encapsulation layers 151 and 153, the planarization layer 125, and the capping layer 140, the anti-oxidation layer 180 is disposed to cover ends of the planarization layer 125 and the capping layer 140. Therefore, even though the first and second inorganic encapsulation layers 151 and 153 are pressed by the spacer to be cracked, the permeation of oxygen into the organic light emitting diode 130 may be suppressed and delayed by the anti-oxidation layer 180. When the oxygen flows thereinto through the crack, the anti-oxidation layer 180 reacts with oxygen to be oxidized to suppress and delay the permeation of oxygen.

FIG. 5 is a cross-sectional view taken along the line II-II' of FIG. 1 and, for example, is a cross-sectional view of a partial area of a non-pad unit of the non-display area NDA. With reference to FIGs. 1 to 5 together, the planarization layer 125 is disposed to extend to at least a part of the non-pad unit of the non-display area NDA. In this area, an end of the planarization layer 125 may be disposed to further extend toward an outer periphery of the non-display area NDA more than an end of the emission layer 132 and an end of the cathode 133. For example, the end of the emission layer 132 and the end of the cathode 133 are located on the planarization layer 125. The capping layer 140 is disposed to continuously cover the side surface of the emission layer 132 from the top surface of the cathode 133. The capping layer 140 is disposed to completely cover the end of the emission layer 132 and the end of the cathode 133. The end of the capping layer 140 may be disposed to be located on the top surface of the planarization layer 125. The end of the capping layer 140 may be disposed to be located on the top surface of the planarization layer 125.

The anti-oxidation layer 180 is disposed to cover the end of the capping layer 140 and the end of the planarization layer 125. The anti-oxidation layer 180 is disposed to continuously cover from the end of the capping layer 140 to the end of the planarization layer 125. The anti-oxidation layer 180 is disposed to cover a part of the top surface and the side surface of the planarization layer 125 that protrudes to the outer periphery of the non-display area NDA more than a part of the top surface and a side surface of the capping layer 140 and the end of the capping layer 140.

The encapsulation layer 150 is disposed on the capping layer 140. For example, the encapsulation layer 150 may include a first inorganic encapsulation layer 151 disposed on the capping layer 140, an organic encapsulation layer 152 disposed on the first inorganic encapsulation layer 151 and a second inorganic encapsulation layer 153 disposed on the organic encapsulation layer 152. Also in the non-pad unit, the first and second inorganic encapsulation layers 151 and 153 are disposed to completely cover the capping layer 140 and the anti-oxidation layer 180. The dam DAM is disposed on the second inorganic encapsulation layer 153. In the non-pad unit, at least a part of the dam DAM overlaps at least a part of the first and second inorganic encapsulation layers 151 and 153, the planarization layer 125, and the capping layer 140, respectively. A thickness of the dam DAM is relatively small in a portion that overlaps at least a part of the first and second inorganic encapsulation layers 151 and 153, the planarization layer 125, and the capping layer 140. Therefore, in an area in which the dam DAM overlaps the first and second inorganic encapsulation layers 151 and 153, the planarization layer 125, and the capping layer 140, the first and second inorganic encapsulation layers 151 and 153 are more vulnerable to pressurization by the spacer.

As described above, in the display device 100 of the present disclosure, in the area in which the dam DAM overlaps the first and second inorganic encapsulation layers 151 and 153, the planarization layer 125, and the capping layer 140, the anti-oxidation layer 180 is disposed to cover ends of the planarization layer 125 and the capping layer 140. Therefore, even though the first and second inorganic encapsulation layers 151 and 153 are pressed by the spacer to be cracked, the permeation of oxygen into the organic light emitting diode 130 may be suppressed and delayed by the anti-oxidation layer 180.

FIG. 6 is a cross-sectional view taken along the line III-III' of FIG. 1 and, for example, is a cross-sectional view of a first area A1 of an area in which a source pad unit DIC is disposed. The source pad unit DIC is disposed at the outside more than the first dam bank DAM_BANK1 that is located at the outside of the dam DAM. The source pad unit DIC may be disposed on the buffer layer 121, but is not limited thereto.

In the first area A1, a low potential power line VSL is disposed on the buffer layer 121. The low potential power line VSL may be disposed on the buffer layer 121 in the non-display area NDA adjacent to the display area DA. The low potential power line VSL may be disposed between the dam DAM and the planarization layer 125.

In the first area A1, the planarization layer 125 and the capping layer 140 do not overlap at least a part of the dam DAM. At least a part of the cathode 133 is not covered by the capping layer 140 and may extend toward the outer periphery of the non-display area NDA. The cathode 133 may be formed to further extend to the outer periphery of the non-display area NDA more than ends of the emission layer 132, the capping layer 140, and the planarization layer 125. The extending cathode 133 is disposed to be electrically connected to the low potential power line VSL. The cathode 133 may be disposed to completely cover the low potential power line VSL.

A low potential power voltage is applied to the low potential power line VSL. The low potential power line VSL may be connected to a pad to which a low potential power voltage is supplied, among various pads provided in the source pad unit DIC. Therefore, the low potential power voltage output from the power generator may be input to the low potential power line VSL through the printed circuit board that is electrically connected to the source pad unit DIC. The cathode 133 is connected to the low potential power line VSL to be supplied with the low potential power voltage.

The first and second inorganic encapsulation layers 151 and 153 are disposed to completely cover the capping layer 140 and the cathode 133 on the low potential power line VSL. At least a part of the dam DAM is disposed to overlap at least a part of the first and second inorganic encapsulation layers 151 and 153.

In the first area A1, the planarization layer 125 and the capping layer 140 that have a relatively low oxygen barrier characteristic do not overlap the dam DAM. Therefore, the rate of defects due to the pressurization of the spacer is relatively low. Further, the cathode 133 extends to the non-display area NDA to be electrically connected to the low potential power line VSL so that it is not necessary to form the anti-oxidation layer 180.

Further, as described above, in the first area A1, a plurality of wiring lines that is electrically connected to the data driving IC is located. Therefore, the anti-oxidation layer 180 may not be formed in the first area A1 so as not to cause the operation failure or short due to the interference therewith.

FIG. 7 is a cross-sectional view taken along the line I-I' of FIG. 2 and, for example, is a cross-sectional view of a second area A2 of an area in which a source pad unit DIC is disposed. A structure of the display device 100 illustrated in FIG. 7 is substantially the same as the configuration illustrated in FIG. 4 except for a structure in which the anti-oxidation layer 180 and the ground pad GNDP are electrically connected by the metal line ML, so that a description of repeated components will be omitted.

As illustrated in FIG. 7, in the second area A2, the anti-oxidation layer 180 and the ground pad GNDP are electrically connected by the metal line ML.

The metal line ML may be disposed on the first substrate 110. One end of the metal line ML may be electrically connected to one end of the anti-oxidation layer 180 by a contact hole formed in the buffer layer 121.

The other end of the metal line ML is disposed at an outer periphery of the non-display area NDA and may be electrically connected to the ground pad GNDP by a contact hole formed in the buffer layer 121. Therefore, the anti-oxidation layer 180 and the ground pad GNDP may be electrically connected by contact holes formed in the metal line ML and the buffer layer 121.

Therefore, the anti-oxidation layer 180 serves as a ground line to suppress a voltage fluctuation of an element and may further improve an operation failure and a display quality. In the display device 100 according to example embodiments of the present disclosure, in a location in which the dam DAM, the planarization layer 125 and the first and second inorganic encapsulation layers 151 and 153 overlap, the anti-oxidation layer 180 is disposed to cover the planarization layer 125. Even though the first and second inorganic encapsulation layers 151 and 153 are cracked by the pressurization by the spacer included in the dam DAM, the anti-oxidation layer 180 may suppress and delay the permeation of oxygen into the organic light emitting diode

130. Therefore, degradation of the organic light emitting diode due to the oxygen may be minimized or reduced.

Further, when an oxygen blocking agent is added into the dam DAM, a ratio of moisture absorbent is relatively reduced, which may degrade the moisture barrier characteristic. However, according to the example embodiments of the present disclosure, the anti-oxidation layer 180 maintains the moisture barrier characteristic to be high and also additionally blocks the oxygen, to significantly improve the reliability.

Further, the anti-oxidation layer 180 is connected to the ground pad GNDP to serve as a ground line. Therefore, the voltage fluctuation of the element is suppressed to improve the operation failure and the display quality.

Example embodiments of the present disclosure can also be described as follows.

According to an aspect of the present disclosure, there is provided a display device. The display device comprises a first substrate on which a display area and a non-display area around the display area are defined; a thin film transistor over the first substrate at a portion corresponding to the display area; a planarization layer over the first substrate and the thin film transistor at a portion corresponding to the display area and at least a portion of the non-display area; an organic light emitting diode on the planarization layer at a portion corresponding to the display area; a capping layer at a portion corresponding to the display area and the at least a part of the non-display area to cover the planarization layer and the organic light emitting diode at a portion corresponding to the display area and the at least a part of the non-display area; and an anti-oxidation layer covering an end of the planarization layer and an end of the capping layer in the non-display area.

The anti-oxidation layer may an electrically conductive material.

The display device may further comprise a second substrate on the organic light emitting diode to be opposite to the first substrate; an adhesive layer between the second substrate and the organic light emitting diode; and a dam in the non-display area between the first and second substrates to enclose the adhesive layer.

The non-display area may include first, second, third, and fourth side areas. A gate pad unit may be on the first substrate in the first and second side areas that are opposite to each other, a source pad unit may be on the first substrate in a third side area, and the fourth side area may be opposite to the third side area, the fourth side area including a non-pad unit. The dam may be on the first substrate to overlap the first, second, third, and fourth side areas of the non-display area to surround the display area. The anti-oxidation layer may overlap at least a portion of the first, second, third, and fourth side areas.

The organic light emitting diode may include an anode electrically connected to the thin film transistor, an organic emission layer on the anode, and a cathode on the organic emission layer.

The third side area in which the source pad unit is disposed includes a middle area and a an adjacent area that are respectively adjacent to respective ends of the middle area. At least a portion of the adjacent areas may overlap the anti-oxidation layer.

In the middle area, the cathode may extend further toward an outer periphery of the non-display area more than ends of the capping layer, the emission layer, and the planarization layer. The cathode may cover side surfaces of the emission layer and the planarization layer.

In the adjacent areas, at least a portion of the planarization layer may overlap at least a portion of the dam, the end of the planarization layer may extend further toward the outer periphery of the non-display area than ends of the emission layer and the cathode, and the anti-oxidation layer may cover a top surface and a side surface of the planarization layer that overlaps the dam.

In the area in first, second, and fourth side areas, the at least a part of the planarization layer may overlap the at least a part of the dam, the end of the planarization layer may extend further toward the outer periphery of the non-display area more than the ends of the emission layer and the cathode, and the anti-oxidation layer may cover the top surface and the side surface of the planarization layer that overlaps the dam.

In the first, second and fourth side areas, and in the adjacent areas of the third side area, at least a portion of the capping layer may overlap the at least a portion of the dam, the end of the capping layer may be on the top surface of the planarization layer, and the anti-oxidation layer may cover a top surface and a side surface of the capping layer that overlaps the dam.

The display device may further comprise an encapsulation layer above the capping layer. The encapsulation layer may include at least one inorganic encapsulation layer. The inorganic encapsulation layer may cover the capping layer and the anti-oxidation layer in the display area and the non-display area.

The inorganic encapsulation layer may overlap the at least a portion of the dam and may completely cover the anti-oxidation layer. In the middle area, the inorganic encapsulation layer may completely cover the cathode.

The source pad unit may include a ground pad, and the anti-oxidation layer may be electrically connected to the ground pad.

The display device may further comprise a metal line on the first substrate in the adjacent areas, and the metal line may electrically connect the anti-oxidation layer and the ground pad.

In another aspect, a display device, having a display area and a non-display area, may comprise a first substrate; a planarization layer over the first substrate in the display area and in at least a portion of the non-display area; an organic light emitting diode on the planarization layer in the display area; a capping layer, in the display area and in the at least the portion of the non-display area, covering the organic light emitting diode; an anti-oxidation layer, in the non-display area, covering an end of the planarization layer and an end of the capping layer.

The anti-oxidation layer may include an electrically conductive material.

The display device may further comprise a second substrate on the organic light emitting diode to be opposite to the first substrate; an adhesive layer between the second substrate and the organic light emitting diode; and a dam in the non-display area between the first and second substrates to enclose the adhesive layer.

The non-display area may include first, second, third, and fourth side areas, wherein a gate pad unit is on the first substrate in the first and second side areas that are opposite to each other, a source pad unit is on the first substrate in a third side area, and a fourth side area opposite to the third side area, the fourth side area including a non-pad unit, and wherein the anti-oxidation layer overlaps at least a portion of the area of first, second, third, and fourth side areas.

In another aspect, a display device, having a display area and a non-display area, may comprises a first substrate; a second substrate; a dam in the non-display area between the first and second substrates to seal the display area; a planarization layer in the display area and in the non-display area to have a portion overlapping the dam; and an anti-oxidation layer covering the portion of the planarization layer overlapping the dam.

The display device may further comprise a capping layer, the anti-oxidation layer covering the portion of the planarization layer overlapping the dam and a portion of the capping layer.

The anti-oxidation layer may include an electrically conductive material.

The non-display area may include a plurality of sides, and at least one of a gate pad unit and a non-pad unit may be on one side of the plurality of sides having the portion of the planarization layer overlapping the dam.

The non-display area may include a plurality of sides, and a source pad unit may be on one side of the plurality of sides where the planarization layer does not overlap the dam.

The display device may further comprise a ground pad wherein the ground pad may be on the one side having the source pad unit.

The display device may further comprise a metal line electrically connecting the anti-oxidation layer and the ground pad.

It will be apparent to those skilled in the art that various modifications and variations can be made in the display device of the present disclosure without departing from the technical idea or scope of the disclosure. Thus, it is intended that the present disclosure cover the modifications and variations of this disclosure provided they come within the scope of the appended claims and their equivalents.

### The disclosure comprises the following items:

1. A display device, comprising:
   a first substrate on which a display area and a non-display area around the display area are defined;
   a thin film transistor over the first substrate at a portion corresponding to the display area;
   a planarization layer over the first substrate and the thin film transistor at a portion corresponding to the display area and at least a portion of the non-display area;
   an organic light emitting diode on the planarization layer at a portion corresponding to the display area;
   a capping layer at a portion corresponding to the display area and the at least a part of the non-display area to cover the planarization layer and the organic light emitting diode at a portion corresponding to the display area and the at least a part of the non-display area; and
   an anti-oxidation layer covering an end of the planarization layer and an end of the capping layer in the non-display area.
2. The display device according to item 1, wherein the anti-oxidation layer includes an electrically conductive material.
3. The display device according to item 1 or item 2, further comprising:
   a second substrate on the organic light emitting diode to be opposite to the first substrate;
   an adhesive layer between the second substrate and the organic light emitting diode; and
   a dam in the non-display area between the first and second substrates to enclose the adhesive layer.4. The display device according to any preceding item, wherein the non-display area includes first, second, third, and fourth side areas, wherein a gate pad unit is on the first substrate in the first and second side areas that are opposite to each other, a source pad unit is on the first substrate in the third side area, and the fourth side area is opposite to the third side area, the fourth side area including a non-pad unit,
   wherein the dam is on the first substrate to overlap the first, second, third, and fourth side areas of the non-display area to surround the display area, and
   wherein the anti-oxidation layer overlaps at least a portion of the first, second, third, and fourth side areas.
5. The display device according to any preceding item, wherein the organic light emitting diode includes an anode electrically connected to the thin film transistor, an organic emission layer on the anode, and a cathode on the organic emission layer.
6. The display device according to any preceding item, wherein the third side area in which the source pad unit is disposed includes a middle area and adjacent areas that are respectively adjacent to respective ends of the middle area, and
   wherein at least a portion of the adjacent areas overlap the anti-oxidation layer.
7. The display device according to any preceding item, wherein, in the middle area, the cathode extends further toward an outer periphery of the non-display area more than ends of the capping layer, the emission layer, and the planarization layer, and
   wherein the cathode covers side surfaces of the emission layer and the planarization layer.
8. The display device according to any preceding item, wherein, in the adjacent areas, at least a portion of the planarization layer overlaps at least a portion of the dam, the end of the planarization layer extends further toward the outer periphery of the non-display area than ends of the emission layer and the cathode, and the anti-oxidation layer covers a top surface and a side surface of the planarization layer that overlaps the dam.
9. The display device according to any preceding item, wherein, in the first, second, and fourth side areas, the at least a part of the planarization layer overlaps the at least a part of the dam, the end of the planarization layer extends further toward the outer periphery of the non-display area more than the ends of the emission layer and the cathode, and the anti-oxidation layer covers the top surface and the side surface of the planarization layer that overlaps the dam.
12. The display device according to any preceding item, wherein, in the first, second, and fourth side areas, and in the adjacent areas of the third side area, at least a portion of the capping layer overlaps the at least the portion of the dam, the end of the capping layer is on the top surface of the planarization layer, and the anti-oxidation layer covers a top surface and a side surface of the capping layer that overlaps the dam.
11. The display device according to any preceding item, further comprising an encapsulation layer above the capping layer, wherein the encapsulation layer includes at least one inorganic encapsulation layer, at least one the inorganic encapsulation layer covering the capping layer and the anti-oxidation layer in the display area and the non-display area.
12. The display device according to any preceding item, wherein the inorganic encapsulation layer overlaps the at least the portion of the dam and completely covers the anti-oxidation layer, and
   wherein, in the middle area, the inorganic encapsulation layer completely covers the cathode.
13. The display device according to any preceding item, wherein the source pad unit includes a ground pad, and the anti-oxidation layer is electrically connected to the ground pad.
14. The display device according to any preceding item, further comprising a metal line on the first substrate in the adjacent areas, the metal line electrically connecting the anti-oxidation layer and the ground pad.
15. A display device having a display area and a non-display area, the display device comprising:
   a first substrate;
   a planarization layer over the first substrate in the display area and in at least a portion of the non-display area;
   an organic light emitting diode on the planarization layer in the display area;
   a capping layer, in the display area and in the at least the portion of the non-display area, covering the organic light emitting diode; and
   an anti-oxidation layer, in the non-display area, covering an end of the planarization layer and an end of the capping layer.
16. The display device according to item 15, wherein the anti-oxidation layer includes an electrically conductive material.
1. The display device according to item 15 or item 16, further comprising:
   a second substrate on the organic light emitting diode to be opposite to the first substrate;
   an adhesive layer between the second substrate and the organic light emitting diode; and
   a dam in the non-display area between the first and second substrates to enclose the adhesive layer. 18. The display device according to any of items 15-17, wherein the non-display area includes first, second, third, and fourth side areas, wherein a gate pad unit is on the first substrate in the first and second side areas that are opposite to each other, a source pad unit is on the first substrate in a third side area, and a fourth side area opposite to the third side area, the fourth side area including a non-pad unit, and
   wherein the anti-oxidation layer overlaps at least a portion of the area of first, second, third, and fourth side areas.
19. A display device having a display area and a non-display area, the display device comprising:
   a first substrate;
   a second substrate;
   a dam in the non-display area between the first and second substrates to seal the display area;
   a planarization layer in the display area and in the non-display area to have a portion overlapping the dam; and
   an anti-oxidation layer covering the portion of the planarization layer overlapping the dam.
20. The display device according to item 19, further comprising a capping layer, the anti-oxidation layer covering the portion of the planarization layer overlapping the dam and a portion of the capping layer.
21. The display device according to item 19 or item 20, wherein the anti-oxidation layer includes an electrically conductive material.
22. The display device according to any of items 19-21, wherein the non-display area includes a plurality of sides, and wherein at least one of a gate pad unit and a non-pad unit is on one side of the plurality of sides having the portion of the planarization layer overlapping the dam.
23. The display device according to any of items 19-22, wherein the non-display area includes a plurality of sides, and wherein a source pad unit is on one side of the plurality of sides where the planarization layer does not overlap the dam.
24. The display device according to any of items 19-23, further comprising a ground pad wherein the ground pad is on the one side having the source pad unit.
25. The display device according to any of items 19-24, further comprising a metal line electrically connecting the anti-oxidation layer and the ground pad.

## Claims

1. A display device, comprising:
a first substrate on which a display area and a non-display area around the display area are defined;
a thin film transistor over the first substrate at a portion corresponding to the display area;
a planarization layer over the first substrate and the thin film transistor at a portion corresponding to the display area and at least a portion of the non-display area;
an organic light emitting diode on the planarization layer at a portion corresponding to the display area;
a capping layer at a portion corresponding to the display area and at least a part of the non-display area to cover the planarization layer and the organic light emitting diode at the portion corresponding to the display area and the at least a part of the non-display area; and
an anti-oxidation layer covering an end of the planarization layer and an end of the capping layer in the non-display area.

2. The display device according to claim 1, wherein the anti-oxidation layer includes an electrically conductive material.

3. The display device according to claim 1 or claim 2, further comprising:
a second substrate on the organic light emitting diode to be opposite to the first substrate;
an adhesive layer between the second substrate and the organic light emitting diode; and
a dam in the non-display area between the first and second substrates to enclose the adhesive layer.

4. The display device according to claim 3, wherein the non-display area includes first, second, third, and fourth side areas, wherein a gate pad unit is on the first substrate in the first and second side areas that are opposite to each other, a source pad unit is on the first substrate in the third side area, and the fourth side area is opposite to the third side area, the fourth side area including a non-pad unit,
wherein the dam is on the first substrate to overlap the first, second, third, and fourth side areas of the non-display area to surround the display area, and
wherein the anti-oxidation layer overlaps at least a portion of the first, second, third, and fourth side areas.

5. The display device according to claim 4, wherein the organic light emitting diode includes an anode electrically connected to the thin film transistor, an organic emission layer on the anode, and a cathode on the organic emission layer.

6. The display device according to claim 5, wherein the third side area in which the source pad unit is disposed includes a middle area and adjacent areas that are respectively adjacent to respective ends of the middle area, and
wherein at least a portion of the adjacent areas overlap the anti-oxidation layer.

7. The display device according to claim 6, wherein, in the middle area, the cathode extends further toward an outer periphery of the non-display area more than ends of the capping layer, the emission layer, and the planarization layer, and
wherein the cathode covers side surfaces of the emission layer and the planarization layer.

8. The display device according to claim 7, wherein, in the adjacent areas, at least a portion of the planarization layer overlaps at least a portion of the dam, the end of the planarization layer extends further toward the outer periphery of the non-display area than ends of the emission layer and the cathode, and the anti-oxidation layer covers a top surface and a side surface of the planarization layer that overlaps the dam.

9. The display device according to claim 8, wherein, in the first, second, and fourth side areas, the at least a part of the planarization layer overlaps the at least a part of the dam, the end of the planarization layer extends further toward the outer periphery of the non-display area more than the ends of the emission layer and the cathode, and the anti-oxidation layer covers the top surface and the side surface of the planarization layer that overlaps the dam.

10. The display device according to claim 9, wherein, in the first, second, and fourth side areas, and in the adjacent areas of the third side area, at least a portion of the capping layer overlaps the at least the portion of the dam, the end of the capping layer is on the top surface of the planarization layer, and the anti-oxidation layer covers a top surface and a side surface of the capping layer that overlaps the dam.

11. The display device according to claim 10, further comprising an encapsulation layer above the capping layer, wherein the encapsulation layer includes at least one inorganic encapsulation layer, the at least one inorganic encapsulation layer covering the capping layer and the anti-oxidation layer in the display area and the non-display area.

12. The display device according to claim 11, wherein the inorganic encapsulation layer overlaps the at least the portion of the dam and completely covers the anti-oxidation layer, and
wherein, in the middle area, the inorganic encapsulation layer completely covers the cathode.

13. The display device according to any of claims 4-12, wherein the source pad unit includes a ground pad, and the anti-oxidation layer is electrically connected to the ground pad.

14. The display device according to any of claims 6-13, further comprising a metal line on the first substrate in the adjacent areas, the metal line electrically connecting the anti-oxidation layer and the ground pad.
